# EUROPÄISCHE PATENTSCHRIFT

(11) **EP 1 883 832 B1**
(45) Veröffentlichungstag und Bekanntmachung des Hinweises auf die Patenterteilung: **17.06.2009**
(21) Anmeldenummer: 06722830.4
(22) Anmeldetag: 28.04.2006
(51) Int. Cl.: G01R 33/3415

(54) **EMPFANGSSPULEN-HALTERUNG FÜR EIN MR-BILDGEBUNGSSYSTEM**
RECEPTION COIL MAINTAINING ELEMENT FOR AN MR-IMAGING SYSTEM
SUPPORT DE BOBINES DE RECEPTION DESTINE A UN SYSTEME D'IMAGERIE PAR RESONANCE MAGNETIQUE

(30) Priorität: 05.05.2005 DE 102005021621
(43) Veröffentlichungstag der Anmeldung: 06.02.2008
(73) Patentinhaber: Noras, Hubert, 97082 Würzburg (DE)
(72) Erfinder: Noras, Hubert, 97082 Würzburg (DE)
(74) Vertreter: Pöhner, Wilfried Anton, Dr.
(86) Internationale Anmeldenummer: PCT/DE2006/000753
(87) Internationale Veröffentlichungsnummer: WO 2006/116980

(56) Entgegenhaltungen:
- EP-A- 0 318 257
- DE-A1-3102004 052 94
- US-B1- 6 650 926
- PATENT ABSTRACTS OF JAPAN Bd. 016, Nr. 086 (C-0916), 3. März 1992 (1992-03-03) & JP 03 272739 A (TOSHIBA CORP), 4. Dezember 1991 (1991-12-04)
- PATENT ABSTRACTS OF JAPAN Bd. 2000, Nr. 21, 3. August 2001 (2001-08-03) & JP 2001 095776 A (TOSHIBA CORP), 10. April 2001 (2001-04-10)

## Beschreibung

Die Erfindung betrifft eine Empfangsspulen-Halterung für ein MR- Bildgebungssystem gemäß dem Oberbegriff des Patentanspruchs 1.

Halterungen für die hier interessierenden für MR- Oberflächen-Empfangsspulen sind allgemein bekannt geworden, z.B. durch die US-6 650 926 B1.
Die US-6 650 926 B1 zeigt eine Empfangsspulen-Halterung für von je einem Gehäuse umgebene, Mehr-Element-(Spulen)-Arrays eines RF-Mehrkanal-Oberflächenempfangsspulensystems. Dieses RF-Mehrkanal-Oberflächenempfangsspulensystem ermöglicht ein Parallelabbildungsverfahren (parallel imaging) für ein MR- Bildgebungssystem eines MR-Tomographen mit einer von seinem Hauptmagneten vorgegebenen Betriebs-Hauptmagnetfeldrichtung. Die Mehr-Element-(Spulen)-Arrays haben je eine Empfangsfläche mit je einem Zentrum mit je einer sie durchquerenden Längsachse haben.

Es ist allgemein bekannt, dass als Oberflächenspulen gestaltete Empfangsspulen eine viel kleinere Geometrie haben als die, welche als Empfangsspulen gestaltete Ganzkörperspulen. Ihr Nachteil ist ihr beschränktes "Field-of View" (=FOV). Oberflächenspulen eignen sich deshalb besonders für medizinische Diagnosen von bestimmten kleinen Regionen auf der Oberfläche und im Inneren des Körpers und/oder seinen Extremitäten. Aber bei Anwendung des Parallelabbildungsverfahrens ("parallel imaging") unter Verwendung von Arrays von mehreren Spulen zum Empfangen eines MR - Signals erzeugen sie Bilder mit hoher Auflösung und mit hoher Nachweisempfindlichkeit bei hoher Bildgebungsgeschwindigkeit.

Der Erfindung liegt die Aufgabe zugrunde eine Halterung für wenigstens zwei, zueinander beabstandete, im Parallelabbildungsverfahren (parallel imaging) arbeitende Mehr-Element- Oberflächen-Empfangsspulen zu schaffen, die eine Optimierung des Parallelabbildungsverfahrens (parallel imaging) ermöglicht.

Diese Aufgabe wird durch die Merkmale des Patentanspruches 1 gelöst.

Die Vorteile der Erfindung liegen insbesondere darin, dass die in zwei räumlich getrennten, vorzugsweise in gleichen Gehäusen angeordneten, im Parallelabbildungsverfahren (sog. "Parallel Imaging") arbeitenden Mehr-Element- Oberflächen-Empfangsspulen gemeinsam, bzw. synchron, direkt oder indirekt abgestützt auf z.B. auf einer Grundplatte, in ihrer räumlichen Lage verändert werden können. Bei idealer Ausrichtung Die beiden Mehr-Element- Oberflächen-Empfangsspulen können derart zueinander ausgerichtet werden (aufeinander zu bewegt werden), dass sich die beiden Empfangsflächen (Field-of-View) der beiden Mehr-Element- Oberflächen-Empfangsspulen gegenseitig mit ihrem größtmöglichen Schatten, z. B. durch Bestrahlung durch polarisiertes Licht, überdecken. Diese Einstellung kann, bei entsprechender Ausstattung, auch dann aufrechterhalten werden, wenn beide Mehr-Element- Oberflächen-Empfangsspulen synchron in gleicher Richtung im Raum bewegt werden.
Bei einer Veränderung des Abstandes der beiden Mehr-Element-Oberflächen-Empfangsspulen zueinander, kann gewährleistet werden, dass sich die beiden Empfangsflächen (Field-of-View) der beiden Mehr-Element- Oberflächen-Empfangsspulen gegenseitig zumindest mit ihren Teilschatten überdecken. Aus einer derartigen gegenseitigen "Teilschatten-Überdeckungs"-Stellung kann/können dann durch manuelle und/oder motorische Betätigung je einer Verstellungseinrichtung ,- die jeweils z.B. form- oder stoffschlüssig mit den Gehäusen der Mehr-Element- Oberflächen-Empfangsspulen verbunden ist -, ein und/oder beide Mehr-Element- Oberflächen-Empfangsspulen so (einzeln oder gemeinsam) im Raum bewegt werden, dass sie jeweils in ihrem gegenseitigen, momentan größtmöglich erreichbaren Schatten liegen, bzw. das jeweils momentan größtmögliche Bildsignal erzeugt wird.
Die Mehr-Element- Oberflächen-Empfangsspulen können in vorteilhafter Weise in Kunststoff-Gehäusen untergebracht werden, die an Einzel-Halterungen aus Kunststoff befestigt sind. Die Gesamt-Halterungen 6 und die Einzel-Halterungen 24, 26, 22, 19, 23 27 bzw. 37, 34, 31, 36, 38, 39 können auf vielfältigste Weise gestaltet werden. Sie können z.B. gerade oder gekrümmte Blattfedern oder z.B. auch biegsame flexible Arme aus MR- tauglichem Material sein. Derartig gestaltete Halterungen ermöglichen es, die Gehäuse mit den Mehr-Element-Oberflächen-Empfangsspulen unmittelbar an den zu untersuchenden Körperteilen anzubringen, d.h. sie stützen sich indirekt auf der Grundplatte ab.
Eine schnelle manuelle, - z.B. zur Reproduzierung einer vorangegangenen Stellung-, Einstellung der Mehr-Element- Oberflächen-Empfangsspulen, bzw. ihrer Gehäuse, wird z.B. erreicht durch die Anbringung von Skalen an den Gelenk/- en mit denen die Gehäuse jeweils am einem Arm oder Einzel-Halterung 24, 26, 22, 19, 23 27; 37, 34, 31, 36, 38, 39 befestigt sind.
Mittels den erfindungsgemäßen Empfangsspulen-Gesamt-Halterung 6 bzw. Einzel-Halterungen 24, 26, 22, 19, 23 27; 37, 34, 31, 36, 38, 39 und deren Anordnung an/in einer Patientenauflage kann die Anzahl der notwendigen unterschiedlichen Ausbildungen von Oberflächenspulen für verschiedene Untersuchungen bedeutend verringert werden. Es können so schwierige Teile des Körpers, wie z.B. Teile des Kopfes, Schulter, Nacken, Prostata, Körpergelenke unter Verwendung der erfindungsgemäßen Empfangsspulen-Halterungen untersucht werden. Außerdem kann das Mehr-Empfangsspulen-Array jeweils äußerst nahe am Körper des zu Untersuchenden plaziert werden, z.B. auch ohne den Körper berühren müssen.
Auch können die Gehäuse mit den Mehr-Element- Oberflächen-Empfangsspulen leicht ausgetauscht werden.
Die erfindungsgemäße Empfangsspulen-Gesamt-Halterung und/die Einzel-Halterungen kann/können so eingerichtet werden, dass sie nur Bewegungen zulassen, die entsprechend der tatsächlichen Magnet-Hauptfeldrichtung der Gradientenspulenanordnung, - horizontal oder vertikal ausgerichtetes Hauptmagnetfeld MH-, sinnvoll sind. Im Ausführungsbeispiel sind die Empfangsspulen-Halterungen für ein horizontal ausgerichtetes Magnet-Hauptfeldrichtung MH eines MR- Tomographen bestimmt.

Ein Ausführungsbeispiel der Erfindung ist anhand Zeichnungen dargestellt und wird im Folgenden näher beschrieben:

Es zeigen:

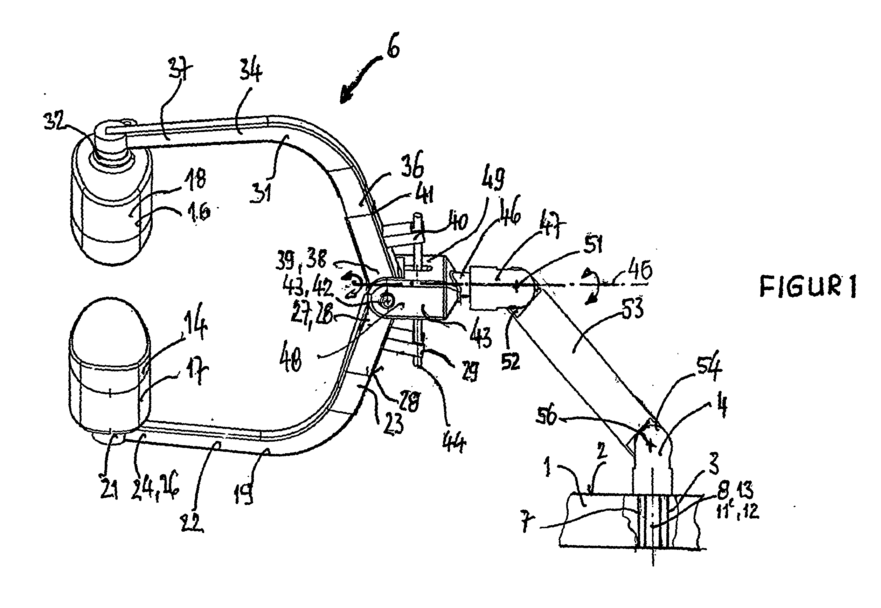

Figur 1 eine Empfangsspulen-Gesamt-Halterung mit zwei Einzel- Halterungen für ein MR-Bildgebungssystem mit zwei Gehäusen mit Mehr-Element- Oberflächen-Empfangsspulen, die in Hauptmagnetfeldrichtung MH des Hauptmagnetfeldgerätes eines MR-Tomographen ausgerichtet sind, wobei die Empfangsspulen-Gesamt-Halterung um 90° um ihre horizontalen Längsachse gedreht ist,

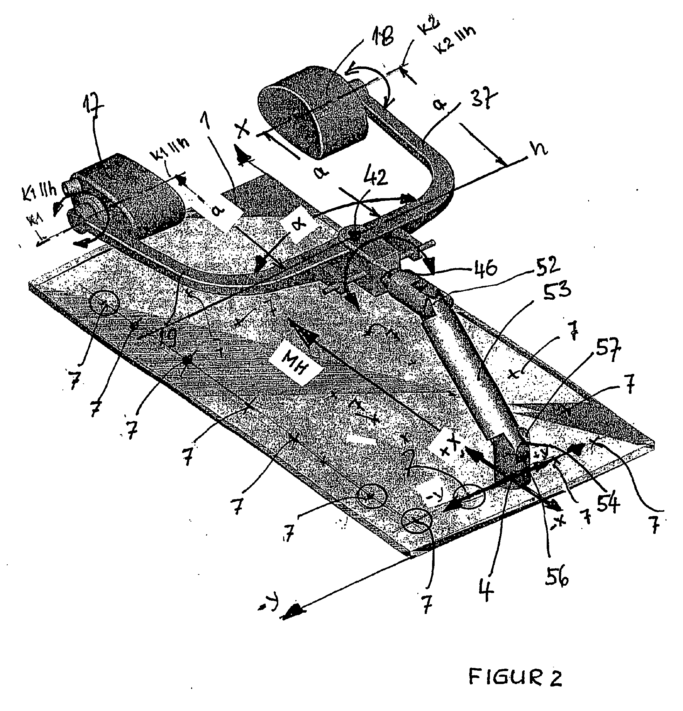

Figur 2 die Empfangsspulen-Gesamt-Halterung für ein MR- Bildgebungssystem nach Figur 1, mit einer entlang der Hauptmagnetfeldrichtung MH in das Innere des MR- Tomographen einbringbaren Grundplatte, an der die Empfangsspulen-Halterungen befestigt sind.

Sämtliche Teile der Empfangsspulen-Halterungen, der Gehäuse und die Grundplatte bestehen aus einem MR- kompatiblem Material.
Auf einer Grundplatte 1 sind regelmäßig verteilt über ihre obere Fläche 2, eine Mehrzahl von Befestigungseinrichtungen 3 für die Füße 4 einer Empfangsspulen-Gesamt-Halterung 6 vorgesehen. Diese Befestigungseinrichtungen 3 können z.B. als Gleitfeder- Verbindungen ausgeführt sein. Hierzu ist eine Mehrzahl von gleichen vertikalen Bohrungen 7 mit je einer vertikalen Federnut 8 in der Grundplatte 1 vorgesehen.
Der Fuß 4 weist z.B. an seinem unteren Teil 11 einen Zylinderzapfen 12 auf, dessen Durchmesser mit der Bohrung 7 auf Schiebesitz abgestimmt ist. Außerdem hat der Zylinderzapfen 12 eine auf die Federnut 8 der Bohrung 7 abgestimmte Flachfeder 13. Der Durchmesser des Fußes 4 ist größer als der Durchmesser der Bohrungen 7. Der in die in Bohrungen 7 eingesteckte Fuß 4 ist verdrehfest angeordnet. Die Mehrzahl der Bohrungen 7 in der Grundplatte 1 dient dazu, Auswahlmöglichkeiten durch die Bohrungen 7 zu schaffen, die als "Stützpunkte" 7 möglichst nahe zum untersuchen Teil der Körpers dienen, um die zwei Mehr-Element- Oberflächen-Empfangsspulen , linke 14 rechte 16, mit jeweils ihren Gehäusen 17, 18 in einstellbaren Abstand zum zu untersuchenden Teil des Körpers zu bringen.

Mit einem linken abgewinkelten Arm 19, vorzugsweise mit dessen Ende, ist mittels eines linken Gelenkes 21 das linke Gehäuse 17 formschlüssig verbunden. Das Gelenk 21 kann ein Gelenk mit zwei Freiheitsgraden oder drei Freiheitsgraden sein. Es kann also z.B. ein feststellbares Kreuzgelenk oder auch ein feststellbares Kugelgelenk sein.
Das linke Gelenk 21 dient dazu, das linke Gehäuse 17 und damit das innerhalb von ihm angeordnete z.B. erste (phased) 4-Element-Spulen-Array einer RF 8-Kanal Oberflächenspule so gut wie möglich an die Kontur einer ersten Seite des zu untersuchenden Teiles des Körpers angenähert wird.

Der linke Arm 19 ist z.B. als einarmiger Winkelhebel mit einem ersten Schenkel 22 und mit einem, mit ihm z.B. stoffschlüssig verbundenen zweiten Schenkel 23 ausgeführt. Der Winkel α, den die beiden Schenkel 22 und 23 einschließen können, kann im Bereich von spitz bis stumpf liegen, z.B. 120°.
Das Ende 24 des linken Armes 19 fällt mit dem Anfang 26 des ersten Schenkels 22 zusammen. Der Anfang 27 des linken Armes 19 fällt mit dem Anfang 28 des zweiten Schenkels 23 zusammen. Der Anfang 27 des linken Armes 19 weist eine Lagerbohrung auf und ist auf einer kurzen horizontalen Strecke, z.B. 25mm, als querschnittsverminderte Zunge mit einer Lagerbohrung ausgeführt. Im Abstand a von z.B. 60mm vom Zentrum der Lagerbohrung ist mit einer Außenfläche 28 des zweiten Schenkels 23 ist ein linker Steg 29, der eine Linksgewindebohrung aufweist, z.B. stoffschlüssig verbunden.
Die Teile 24,26,22,19,23,27 bilden eine linke Einzel-Halterung für das linke Gehäuse 17.

Mit einem rechten abgewinkelten Arm 31, vorzugsweise mit dessen Ende, ist mittels eines linken Gelenkes 32 das rechte Gehäuse 18 formschlüssig verbunden. Das Gelenk 32 kann ein Gelenk mit zwei Freiheitsgraden oder drei Freiheitsgraden sein. Es kann z.B. ein feststellbares Kreuzgelenk oder auch ein feststellbares Kugelgelenk sein.
Das Gelenk 32 dient dazu, das rechte Gehäuse 18 und damit das innerhalb von ihm angeordnete z.B. zweite (phased) 4-Element-Spulen-Array der RF 8-Kanal Oberflächenspule so gut wie möglich an die Kontur der anderen Seite des zu untersuchenden Teiles des Körpers angenähert wird.
Der rechte Arm 31 ist z.B. als einarmiger Winkelhebel mit einem ersten rechten Schenkel 34 und mit einem, mit ihm z.B. stoffschlüssig verbundenen zweiten rechten Schenkel 36 ausgeführt. Der Winkel = α, den die beiden Schenkel 34 und 36 einschließen kann im Bereich von spitz bis stumpf liegen, z.B. 120°.
Das Ende 37 des rechten Armes 31 fällt mit dem Anfang 37 des ersten rechten Schenkels 34 zusammen. Der Anfang 38 des rechten Armes 31 fällt mit dem Anfang 39 des zweiten, rechten Schenkels 36 zusammen. Der Anfang 38 des rechten Armes 31 weist auf einer kurzen horizontalen Strecke, z.B. 25mm, zwei beabstandete, horizontale mit einer Lagerbohrung versehene Stege auf. Im Abstand a von z.B. 60mm vom Zentrum der Lagerbohrung ist mit einer Außenfläche 41 des zweiten Schenkels 36 ist ein rechter Steg 40, der eine Rechtsgewindebohrung aufweist, z.B. stoffschlüssig verbunden.
Die Teile 37,34,31,36,36,39 bilden eine rechte Einzel-Halterung für das rechte Gehäuse 18.

Der Anfang 27 des linken Armes 19 und der Anfang des rechten Armes 31 sind über ihre Lagerbohrungen auf z.B. in einem Drehgelenk mit dem Freiheitsgrad f=1, z.B. auf einem Splintbolzen 42 (Schwenkzentrum) eines Gabelgelenkes 43 mit dem Freiheitsgrad f=1 schwenkbar gelagert.
Im Ausführungsbeispiel kommt der Anfang 27 des linken Armes 19 in Form einer Zunge zwischen die zwei beabstandeten, horizontalen mit je einer Lagerbohrung versehene Stege des Anfang 38 des rechten Armes 31 zu liegen. Alle drei Lagerbohrungen werden gemeinsam auf den Splintbolzen des Drehgelenkes 43 aufgefädelt.
Zur Erzeugung einer vorzugsweise synchronen Schwenkbewegung um das Schwenkzentrum 42 des Gelenkes 43 ist ein manueller oder motorischer Antrieb 44 vorgesehen.
In seiner einfachsten Form besteht er aus einer im Inneren des Gelenkes 43 antreibbar gelagerten und abgebundenen Gewindespindel. Sie hat ein linkes Gewindestück und ein rechtes Gewindestück. Z.B. am äußeren Ende des linken Gewindestückes treibt ein Antrieb an.
Das Außen- Linksgewinde des linken Gewindestückes der Gewindespindel steht mit einem Innen-Linksgewinde durch eine Kugel eines linken Kugelgelenkes in Eingriff. Das Kugelgelenk ist z.B. am Ende eines linken Schlittens befestigt, der in einer längs ausgerichteten Führung im linken Steg 29 bewegbar ist. Bei einer Rotation der Gewindespindel wird über den linken Steg 29 eine Schwenkbewegung des linken Armes 19 erzeugt.
Das Rechtsgewinde des rechten Gewindestückes der Gewindespindel steht mit einem Innen-Rechtsgewinde durch eine Kugel eines rechten Kugelgelenkes in Eingriff. Das Kugelgelenk ist z.B. am Ende eines rechten Schlittens befestigt, der in einer längsausgerichteten Führung im rechten Steg 29 bewegbar ist. Bei einer Rotation der Gewindespindel wird über den rechten Steg 40 eine Schwenkbewegung des rechten Armes 31 bewirkt.
Zur Anpassung der Dickeneinstellung auf das zu untersuchende Körperteil muss der Abstand des ersten zweiten (phased) 4-Element-Spulen-Array einer RF 8-Kanal Oberflächenspule zum zweiten phasengesteuertes (phased) 4-Element-Spulen-Array einer RF 8-Kanal Oberflächenspule entsprechend verändert werden. Dieses geschieht z.B. durch über eine Rotation der Gewindespindel. Je nach ihrer Drehrichtung der Gewindespindel werden die beiden Arme 19 und 31 um ihre gemeinsame Rotationsachse 42 synchron aufeinander zu - bzw. von einander weg bewegt. Den Armen 19,31 folgen die an ihnen befestigten Gehäuse 17 und 18 mit ihrem ersten und zweiten phasengesteuerten (phased) 4-Element-Spulen-Array einer RF 8-Kanal Oberflächenspule. Im Groben bleibt eine Parallelabbildung erhalten. Die Feineinstellung geschieht über Verstellung der Gehäuse 17 und 18.
Anders ausgedrückt, die Empfangsspulen-Halterungen für ein MR- Bildgebungssystem sind zum Betrieb von zwei Mehr-Element-(Spulen)-Arrays einer RF Mehrkanal-Oberflächenempfangsspule ausgebildet. Jede der beiden phasengesteuerten Mehr-Element-(Spulen)-Arrays hat je eine Empfangsfläche mit je einem Zentrum mit je einer sie durchquerenden Längsachse k1, k2. Beide Mehr-Element-(Spulen)-Arrays (14; 16) sind an je einem bewegbaren Arm 19,31 oder Einzel-Halterung z.B. um eine gemeinsame Schwenkachse schwenkbaren Arm 19, 31 angeordnet. Aus der beispielsweisen Anordnung ergibt sich, dass eine entlang der Längsachse des Zentrums der linken Empfangsfläche des linken Mehr-Element-(Spulen)-Arrays 14 aufgespannte vertikale linke Ebene und eine entlang der Längsachse des Zentrums der rechten Empfangsfläche des rechten Mehr-Element-(Spulen)-Array 16 aufgespannte vertikale rechte Ebene parallel und beabstandet sind zu einer entlang der Schwenkachse 42 bzw. 46 aufgespannten, vertikalen, ersten Ebene. Hieraus ergibt sich, dass je nach (gemeinsam) eingestellter Arbeitsstellung der Mehr-Element-(Spulen)-Array 14 jeweils die linke Ebene und die rechte Ebene von der ersten Ebene einen gleichen oder annähernd gleichen Abstand b haben. Der Abstand b der linken Ebene und der Abstand b der rechten Ebene von der ersten Ebene ist veränderbar, jedoch sind beide Abstände immer untereinander gleich oder annähernd gleich, wenn eine gemeinsame, d.h. eine synchrone Bewegung der linken Einzel-Halterung 24, 26, 22, 19, 23 27 und der rechten Einzel-Halterung 37, 34, 31, 36, 38, 39 mit ihren Gehäusen 17,14 bzw. 18,16.

In manchen Fällen ist eine getrennte Bewegung der Einzel-Halterungen erwünscht. Auch dieses ist mit dem Gegenstand dieser Erfindung möglich.

Das Gelenk 43 ist auf einem Zapfen 46 eines zweiten Gabelgelenkes 47 mit Freiheitsgrad f=1 abgebunden und rotier- und in jeder Rotationsstellung festsetzbar gelagert. Zwischen linkem Steg 48 und rechtem Steg 49 des Gabelgelenkes 47 ist auf einem Bolzen 51 und um dessen Rotationsachse schwenkbar und festsetzbar ein erstes Ende 52 einer Stange 53 gelagert. Die Rotationsachse des Bolzens 51 ist immer quer (90°) zur Hauptmagnetfeldrichtung MH ausgerichtet.
Oben auf dem Fuß 4 ist verdrehfest ein weiteres Gabelgelenk 54 mit Freiheitsgrad f=1 vorgesehen. Zwischen linkem Steg 56 und rechtem Steg 57 des Gabelgelenkes 54 ist auf einem Bolzen 56 und dessen Rotationsachse schwenkbar und festsetzbar ein zweites Ende 57 der Stange 53 gelagert. Die Rotationsachse des Bolzens 56 ist immer quer (90°) zur Hauptmagnetfeldrichtung MH ausgerichtet.

Durch die Anordnung der beiden Gabelgelenke 47 und 54 ist es möglich die gesamte Empfangsspulen-Gesamt-Halterung 6,- ohne, dass eine Querbewegung zur Hauptmagnetfeldrichtung MH stattfinden kann-, in und entgegen Hauptmagnetfeldrichtung MH zu verschieben.

Anstatt der Stange 53 mit den beiden Gabelgelenken 47 und 54 zur Längsbewegung der Empfangsspulen-Gesamt-Halterung 6 bzw. der Einzel-Halterungen 24, 26, 22, 19, 23 27 bzw. 37, 34, 31, 36, 38, 39 auf der Grundplatte 1 sind auch andere technische Mittel, die biegsam in einer Richtung, verdrehfest und in jeder Biegeposition feststellbar sind, anwendbar, z.B. flexible Arme.

Eine Ortsveränderung der Empfangsspulen-Gesamt-Halterung 6 bzw. der Einzel-Halterungen, -wenn es erwünscht ist-, entlang der oberen Fläche 2 der Grundplatte 1 ist nicht nur mittels Passbohrungen 7 möglich. Diese Art der Ortsveränderung der Empfangsspulen-Gesamt-Halterung 6 bzw. der Einzel-Halterungen 24, 26, 22, 19, 23 27 bzw. 37, 34, 31, 36, 38, 39 ist nur ein einfaches Ausführungsbeispiel mit z.B einer Führung. So könnten z.B. auch in oder auf der Grundplatte 1 in-, parallel oder quer zur HauptMagnetfeldrichtung MH zur oberen Fläche 2 hin offene Gleit- Gerad- Führungen, z.B. schwalbenschwanzförmige Führungsnuten vorgesehen sein. In den Führungsnuten (fester Teil der Führung) könnte ein an das Schwalbenschwanzprofil angepasstes Gleitstück (bewegliches Teil der Führung) vorgesehen werden, auf dem dann der Fuß 4 für Halterungen 6 bzw. 24, 26, 22, 19, 23 27 bzw. 37, 34, 31, 36, 38, 39 befestigt werden könnten. Das Gleitstück wäre leicht verschieb und arretierbar. Also als ebene Bewegung des Gleitstückes, d.h. der Empfangsspulen-Gesamt-Halterung 6 .
Die Gleitstücke könnten z.B. mittels MR-tauglichen Getrieben und Motoren (Hydromotoren), Servo-Zylinder usw. wahlweise bewegt und/oder festgesetzt werden.
Die Gesamt-Halterung 6 kann auch anderen Orts als an der Grundplatte 1 befestigt werden. Z.B. direkt oder indirekt am MR - Gerät befestigt sein.

Zusammenfassend: Es soll eine Empfangsspulen-Halterung für von je einem Gehäuse umgebenen Mehr-Element-(Spulen)-Arrays einer RF Mehrkanal-Oberflächenempfangsspule zur Ermöglichung eines Parallelabbildungsverfahrens (parallel imaging) für ein MR- Bildgebungssystem eines MR- Tomographen mit einer von seinem Hauptmagneten vorgegebenen Betriebs-Hauptmagnetfeldrichtung (MH) geschaffen werden. Die Mehr-Element-(Spulen)-Arrays haben je eine Empfangsfläche mit je einem Zentrum mit je einer sie durchquerenden Längsachse k1, k2. Die Gehäuse 18, 17 mit dem Mehr-Element-(Spulen)-Array können mittels eines Gelenkes 21 bzw.32 am Ende 24 bzw. 37 der Einzel-Halterungen 24, 26, 22, 19, 23 27 bzw. 37, 34, 31, 36, 38, 39 je ein die Gehäuse 17 bzw. 18) befestigt werden.

Die Anfänge 27 bzw. 39 der Einzel-Halterungen 24, 26, 22, 19, 23 27 bzw. 37, 34, 31, 36, 38, 39 können form- oder stoffschlüssig verbunden sein.
Es ist eine, in das Innere eines MR-Tomographen einbringbare Grundplatte 1 vorgesehen. Die Grundplatte 1 weist eine Anzahl von Befestigungseinrichtungen 7 für die Einzel-Halterungen 24, 26, 22, 19, 23 27 bzw. 37, 34, 31, 36, 38, 39 auf.
Als Befestigungseinrichtungen 7 können eine Anzahl von Gerad-Führungen und/oder Gleitfeder-Verbindungen vorgesehen werden.
An der Grundplatte 1 der feste Teil der Führung und/oder Gleitfeder- Verbindung angebracht. Der feste Teil der Gerad- Führungen und/oder Gleitfeder- Verbindung ist in- und/ oder quer oder seitlich parallel zur vorgesehenen Betriebs-Hauptmagnetfeldrichtung (MH) des Hauptmagnetfeldes des vorgesehenen MR-Tomographen ausgerichtet. Die Anfänge 27,39 der beiden Einzel-Halterungen 24, 26, 22, 19, 23 27; 37, 34, 31, 36, 38, 39 können direkt oder indirekt mit je einem oder mit einem einzigen gemeinsamen, beweglichen Teil der Gerad- Führung, z.B. dem Profil der festen Führung angepasste bewegbare Gleitstücke oder Gleitfeder- Verbindungen verbunden sind. D.h. die beweglichen Teile der Führung und Gleitfeder- Verbindung und der feste Teil der Führung sind mittels Schiebesitz formschlüssig verbunden.
Bei einer weiteren Ausführung ist mindestens eine der beiden Einzel-Halterungen 24, 26, 22, 19, 23 27; 37, 34, 31, 36, 38, 39 direkt oder indirekt an einem beweglichen Teil 43 eines Lagers 43, 46 befestigt. Der bewegliche Teil 43 des Lagers 43, 46 ist auf einem tragenden Teil 46 des Lagers 43, 46 rotierbar gelagert. Hierbei ist die Längsachse des tragendes Teils 46 in- und entgegen vorgesehener Betriebs-Hauptmagnetfeldrichtung (MH) oder in horizontaler Richtung parallel zu dieser zwangsausgerichtet. Das tragende Teil 46 stützt sich direkt oder indirekt auf der Grundplatte 1 ab. Auch ist sein vertikaler Abstand zu der Grundplatte 1 einstellbar.
Auch ist Abstand der Gehäuse 18,17 einander, quer zur vorgesehenen Betriebs-Hauptmagnetfeldrichtung (MH) gesehen, z.B. durch Verschieben der Gleitstücke (Füße) mit den mit ihnen form- oder stoffschlüssig verbundenen Einzel-Halterungen.
Die Lage der Gehäuse 18,17 mit ihrem Mehr-Element-(Spulen)-Array 14; 16 ist in- und entgegen zu der vorgesehenen Betriebs-Hauptmagnetfeldrichtung (MH) gesehen, verstellbar. Hierzu können z.B. die Einzel-Halterungen 24, 26, 22, 19, 23 27; 37, 34, 31, 36, 38, 39 entsprechende längsausgerichtete Gerad- Führungen aufweisen, an deren beweglichen und fixierbaren Teilen die Gehäuse 18,17 über die Gelenke 32, 21 verbunden sind.
Die Gelenke 21; 32 sind schwenk- und arretierbar und haben einen Freiheitsgrad f=2 oder f=3.
Die Anfänge 27, 39 der zwei Einzel-Halterungen 24, 26, 22, 19, 23 27; 37, 34, 31, 36, 38, 39 sind z.B. mittels eines Gelenkes 42,43 verbunden. So kann der Öffnungswinkel = α zwischen den zwei Einzel-Halterungen 24, 26, 22, 19, 23 27; 37, 34, 31, 36, 38, 39 in wahlfreier Größe eingestellt werden.

### Bezugszeichenliste

- 1: Grundplatte
- 2: Fläche, obere
- 3: Befestigungseinrichtung
- 4: Fuß
- 5: -
- 6: Empfangsspulen- Halterung
- 7: Bohrung, vertikal
- 8: Federnut, vertikal
- -: -
- 10: -
- 11: Teil, unterer (4)
- 12: Zylinderzapfen
- 13: Flachfeder
- 14: Mehr-Element-Oberflächen-Empfangsspule, rechte
- 15: -
- 16: Mehr-Element-Oberflächen-Empfangsspule, linke
- 17: Gehäuse, linkes
- 18: Gehäuse, rechtes
- 19: Arm, abgewinkelter, linker
- 20 -:
- 21: Gelenk, linkes
- 22: Schenkel, erster
- 23: Schenkel, zweiter
- 24: Ende von 19
- 25: -
- 26: Anfang von 22
- 27: Anfang von 19
- 28: Außenfläche von 23
- 29: Steg, linker
- 30 -:
- 31: Arm, abgewinkelter, rechter
- 32: Gelenk, linkes
- 33: -
- 34: Schenkel, erster, rechter von 31
- 35: -
- 36: Schenkel, zweiter, rechter
- 37: Ende, rechter Schenkel (34)
- 38: Anfang, von 31
- 39: Anfang, von 36
- 40: Steg, rechter
- 41: Außenfläche von 36
- 42: Splintbolzen
- 43: Gabelgelenk, beweglicher Teil
- 44: Antrieb für 19 und 31
- 45: -
- 46: Zapfen
- 47: Gabelgelenk, zweites
- 48: Steg, linker von 47
- 49: Steg, rechter von 47
- 50: -
- 51: Bolzen von 47
- 52: Ende von 53
- 53: Stange
- 54: Gabelgelenk, erstes
- 55: -
- 56: Bolzen von 54
- 57: Ende, zweites von 53
- 58: -
- 59: -

## Patentansprüche

1. Empfangsspulen-Halterung für von je einem Gehäuse umgebene MehrElement-(Spulen)-Arrays eines RF-Mehrkanal-Oberflächenempfangsspulensystems zur Ermöglichung eines Parallelabbildungsverfahrens (parallel imaging) für ein MR-Bildgebungssystem eines MR-Tomographen mit einer von seinem Hauptmagneten vorgegebenen Betriebs-Hauptmagnetfeldrichtung (MH), wobei jede Spule der phasengesteuerten Mehr-Element-(Spulen)-Arrays je eine Empfangsfläche mit einem Zentrum und mit einer sie durchquerenden Längsachse (k1 ,k2) hat,
**dadurch gekennzeichnet,**
**dass** pro Gehäuse eine von den Array-Gehäusen separate Halterung (24, 26, 22, 19, 23 27; 37, 34, 31, 36, 38, 39) vorgesehen ist,
und **dass** die Gehäuse (18, 17) mit je einem Mehr-Element-(Spulen)-Array mittels eines Gelenkes (21, 32) am Ende (24, 37) je einer Halterung (24, 26, 22, 19, 23 27; 37, 34, 31, 36, 38, 39) befestigt sind.

2. Empfangsspulen-Halterung nach Anspruch 1, **dadurch gekennzeichnet, dass** die Halterungen (24, 26, 22, 19, 23 27; 37, 34, 31, 36, 38, 39) als Blattfedern gestaltet sind.

3. Empfangsspulen-Halterung nach Anspruch 2, **dadurch gekennzeichnet, dass** die Halterungen (24, 26, 22, 19, 23 27; 37, 34, 31, 36, 38, 39) biegesteif oder biegeelastisch oder federsteif sind.

4. Empfangsspulen-Halterung nach Ansprüchen 1 bis 3, **dadurch gekennzeichnet, dass** die Anfänge (27, 39) der zwei Halterungen (24, 26, 22, 19, 23 27; 37, 34, 31, 36, 38, 39) form- oder stoffschlüssig verbunden sind.

5. Empfangsspulen-Halterung nach Ansprüchen 1 bis 4, **dadurch gekennzeichnet, dass** die Anfänge (27, 39) der zwei Halterungen (24, 26, 22, 19, 23 27; 37, 34, 31, 36, 38, 39) mittels eines Gelenkes (42,43) verbunden sind.

6. Empfangsspulen-Halterung nach Ansprüchen 1 bis 5, **dadurch gekennzeichnet, dass** die zusammengefügten zwei Halterungen (24, 26, 22, 19, 23 27; 37, 34, 31, 36, 38, 39) als Druckfeder gestaltet ist, deren Enden mit den an ihnen angebrachten Gehäusen (18,17) sich gegenüberliegen.

7. Empfangsspulen-Halterung nach Ansprüchen 1 bis 6., **dadurch gekennzeichnet, dass** eine, in das Innere eines MR-Tomographen einbringbare Grundplatte (1) vorgesehen ist, dass die Grundplatte (1) eine Anzahl von Befestigungseinrichtungen (7) für die Halterungen (24, 26, 22, 19, 23 27; 37, 34, 31, 36, 38, 39) aufweist.

8. Empfangsspulen-Halterung nach Ansprüchen 1 bis 7, **dadurch gekennzeichnet, dass** als Befestigungseinrichtungen (7) eine Anzahl von Gerad-Führungen und/oder Gleitfeder-Verbindungen vorgesehen sind.

9. Empfangsspulen-Halterung nach Anspruch 8, **dadurch gekennzeichnet, dass** an der Grundplatte (1) der feste Teil der Führung und/oder Gleitfeder- Verbindung vorgesehen ist.

10. Empfangsspulen-Halterung nach Ansprüchen 1 bis 9, **dadurch gekennzeichnet, dass** der feste Teil der Gerad- Führungen und/oder Gleitfeder- Verbindung in- und/ oder quer oder seitlich parallel zur vorgesehenen Betriebs-Hauptmagnetfeldrichtung (MH) des Hauptmagnetfeldes des vorgesehenen MR-Tomographen ausgerichtet sind, dass die Anfänge (27,39) der beiden Halterungen (24, 26, 22, 19, 23 27; 37, 34, 31, 36, 38, 39) direkt oder indirekt mit je einem oder mit einem einzigen gemeinsamen, beweglichen Teil der GeradFührung oder Gleitfeder- Verbindung verbunden sind, dass die beweglichen Teile der Führung und Gleitfeder- Verbindung und der feste Teil der Führung mit Schiebesitz formschlüssig verbunden sind.

11. Empfangsspulen-Halterung nach Ansprüchen 1 bis 10, **dadurch gekennzeichnet, dass** mindestens eine der Halterungen (24, 26, 22, 19, 23 27; 37, 34, 31, 36, 38, 39)direkt oder indirekt an einem beweglichen Teil (43) eines Lagers (43, 46) befestigt sind, dass der bewegliche Teil (43) des Lagers (43, 46) um ein tragendes Teil (46) des Lagers (43, 46) rotierbar angeordnet ist, dass die Längsachse des tragendes Teils (46) in- und entgegen vorgesehener Betriebs-Hauptmagnetfeldrichtung (MH) oder in horizontaler Richtung parallel zu dieser zwangsausgerichtet ist und sich das tragende Teil (46) direkt oder indirekt auf der Grundplatte (1) abstützt und sein vertikale Abstand zu dieser einstellbar ist.

12. Empfangsspulen-Halterung nach Ansprüchen 1 bis 11, **dadurch gekennzeichnet, dass** der Abstand der Gehäuse (18,17) mit ihrem Mehr-Element-(Spulen)-Array (14; 16) zu einander, quer zur vorgesehenen Betriebs-Hauptmagnetfeldrichtung (MH) gesehen, einstellbar ist.

13. Empfangsspulen-Halterung nach Ansprüchen 1 bis 12 **dadurch gekennzeichnet, dass** die Lage der Gehäuse (18,17) mit ihrem Mehr-Element-(Spulen)-Array (14; 16) in- und entgegen, zu der vorgesehenen Betriebs-Hauptmagnetfeldrichtung (MH) gesehen, verstellbar ist.

14. Empfangsspulen-Halterung nach Ansprüchen 1 bis 13, **dadurch gekennzeichnet, dass** die Gehäuse (17; 18) im Bereich des Endes (24,37) ihrer Halterungen (24, 26, 22, 19, 23 27; 37, 34, 31, 36, 38, 39) mittels eines Gelenkes (21; 32) mit 2 oder 3 Freiheitsgraden schwenkbar und arretierbar angeordnet sind.

## Claims

1. A reception-coil holder for a multielement (coil) array, which is surrounded by a housing in each case, of an RF multichannel surface reception coil to permit parallel imaging for an MR imaging system of an MR tomograph with an operating main magnetic field direction (MH) determined by its main magnet, each coil of the phase-controlled multielement (coil) array having in each case a receiving face comprising a centre and comprising a longitudinal axis (k1, k2) passing through it, **characterized in that**
a holder (24, 26, 22, 19, 23 27; 37, 34, 31, 36, 38, 39) which is separate from the array housings is provided per housing
and **in that** said housing (18, 17) with the multielement (coil) array can be fixed at the end (24, 37) of one holder (24, 26, 22, 19, 23 27; 37, 34, 31, 36, 38, 39) in each case by means of a joint (21, 32).

2. Reception-coil holder according to claim 1, **characterised in that** the holders (24,26, 22, 19, 23 27; 37, 34, 31, 36, 38, 39) are designed as leaf springs.

3. Reception-coil holder according to claim 2, **characterised in that** the holders (24, 26, 22, 19, 23 27; 37, 34, 31, 36, 38, 39) are designed so as to be flexurally rigid or flexurally elastic or resiliently rigid.

4. Reception-coil holder according to claims 1 to 3, **characterised in that** the starts (27, 39) of the two holders (24, 26, 22, 19, 23 27; 37, 34, 31, 36, 38, 39) are interlockingly or integrally connected.

5. Reception-coil holder according to claims 1 to 4, **characterised in that** the starts (27, 39) of the two holders (24, 26, 22, 19, 23 27; 37, 34, 31, 36, 38, 39) are connected via a joint (42, 43).

6. Receiving-coil holder according to claims 1 to 5, **characterised in that** the assembled two holders (24, 26, 22, 19, 23 27; 37, 34, 31, 36, 38, 39) are designed as compression springs, the ends of which are opposite to the housings (18, 17), which are mounted on them.

7. Reception-coil holder according to claims 1 to 6, **characterised in that** a base plate (1), which can be introduced into the interior of an MR tomograph is provided and **in that** the base plate (1) has a number of fastening devices (7) for the holders (24, 26, 22, 19, 23, 27; 37, 34, 31, 36, 38, 39).

8. Reception-coil holder according to claims 1 to 7, **characterised in that,** as fastening devices (7), a number of straight guides and/or sliding key connections are provided.

9. Reception-coil holder according to claim 8, **characterised in that** the fixed portion of the guide and/or sliding key connection is provided on the base plate (1).

10. Reception-coil holder according to claims 1 to 9, **characterised in that** the fixed portion of the straight guides and/or sliding key connection are oriented in and/or transverse to or laterally parallel to the provided operating main magnetic field direction (MH) of the main magnetic field of the provided MR tomograph, and **in that** the starts (27, 39) of the two holders (24, 26, 22, 19, 23 27; 37, 34 31, 36, 38, 39) can be directly or indirectly connected with one in each case, or with a single, common movable portion of the straight guide or sliding key connection, and **in that** the movable portions of the guide and sliding key connection and the fixed portion of the guide with sliding seat are interlockingly connected.

11. Reception-coil holder according to claims 1 to 10, **characterised in that** at least one of the holders (24, 26, 22, 19, 23 27; 37, 34 31, 36, 38, 39) can be directly or indirectly fastened on a movable portion (43) of a bearing (43, 46), that the movable portion (43) of the bearing (43, 46) is arranged so as to be rotatable around a supporting portion (46) of the bearing (43, 46), that the longitudinal axis of the supporting portion (46) is positively oriented in and opposite to the operating main magnetic field direction (MH) or parallel thereto in a horizontal direction and the supporting part (46) is supported directly or indirectly on the base plate (1) and its vertical distance thereto is adjustable.

12. Reception-coil holder according to claim 1 to 11, **characterised in that** the distance between the housings (18, 17) with their multielement (coil) arrays (14; 16) is adjustable seen in and opposite to the provided operating main magnetic field direction (MH).

13. Reception-coil holder according to claim 1 to 12, **characterised in that** the position of the housings (18, 17) with their multielement (coil) arrays (14; 16) is adjustable seen in and opposite to the provided operating main magnetic field direction (MH).

14. Reception-coil holder according to claims 1 to 13, **characterised in that** the housings (17; 18), in the region of the end (24, 37) of their holders (24, 26, 22, 19, 23 27; 37, 34, 31, 36, 38, 39), are pivotably and arrestably arranged by means of a joint (21; 32) with the degrees of freedom 2 or 3.

## Revendications

1. Fixation de bobine réceptrice pour les arrays (de bobine) multiéléments entourés à chaque fois d'un boîtier du système de bobines réceptrices de surface multicanaux RF destiné à permettre au procédé d'imagerie parallèle d'un système d'imagerie MR d'un tomographe MR ayant une direction de champ magnétique principal (MH) de service donnée par un de ses principaux aimants, sachant que chaque bobine des arrays (de bobine) multiéléments à régulation par phase a une surface de réception avec un centre et avec un axe longitudinal (k1, k2) qui la traverse,
**caractérisé par le fait qu'**une fixation (24, 26, 22, 19, 23, 27, 37, 34, 31, 36, 38, 39) séparée des boîtiers d'array est prévue pour chaque boîtier,
et que les boîtiers (18, 17) ayant chacun un array (de bobine) multiéléments sont chacun fixés au moyen d'une articulation (21, 32) à l'extrémité (24, 37) d'une fixation (24, 26, 22, 19, 23, 27, 37, 34, 31, 36, 38, 39).

2. Fixation de bobine réceptrice selon la revendication 1,
**caractérisée par le fait que** les fixations (24, 26, 22, 19, 23, 27, 37, 34, 31, 36, 38, 39) sont conçues sous la forme de ressorts à lames.

3. Fixation de bobine réceptrice selon la revendication 2,
**caractérisée par le fait que** les fixations (24, 26, 22, 19, 23, 27, 37, 34, 31, 36, 38, 39) sont rigides au pliage ou ont une élasticité au pliage ou ont des ressorts rigides.

4. Fixation de bobine réceptrice selon les revendications 1 à 3,
**caractérisée par le fait que** les départs (27, 39) des deux fixations (24, 26, 22, 19, 23, 27, 37, 34, 31, 36, 38, 39) sont reliés par des formes ou des matériaux complémentaires.

5. Fixation de bobine réceptrice selon les revendications 1 à 3,
**caractérisée par le fait que** les départs (27, 39) des deux fixations (24, 26, 22, 19, 23, 27, 37, 34, 31, 36, 38, 39) sont reliés par une articulation (42, 43).

6. Fixation de bobine réceptrice selon les revendications 1 à 5,
**caractérisée par le fait que** les deux fixations (24, 26, 22, 19, 23, 27, 37, 34, 31, 36, 38, 39) assemblées sont conçues sous la forme de ressorts de pression dont les extrémités et les boîtiers (18, 17) posés sur elles sont situées en face l'une de l'autre.

7. Fixation de bobine réceptrice selon les revendications 1 à 6,
**caractérisée par le fait qu'**une plaque de base (1) pouvant être insérée à l'intérieur d'un tomographe MR est prévue, que cette plaque de base (1) présente un certain nombre de dispositifs de fixation (7) pour les fixations (24, 26, 22, 19, 23, 27, 37, 34, 31, 36, 38, 39).

8. Fixation de bobine réceptrice selon les revendications 1 à 7,
**caractérisée par le fait qu'**un certain nombre de guidages droits et/ou des liaisons par ressorts coulissants sont prévus en tant que dispositifs de fixation (7).

9. Fixation de bobine réceptrice selon la revendication 8,
**caractérisée par le fait que** la partie fixe du guidage et/ou de la liaison par ressort coulissant est prévue sur la plaque de base.

10. Fixation de bobine réceptrice selon les revendications 1 à 9,
**caractérisée par le fait que** la partie fixe des guidages droits et/ou de la liaison par ressort coulissant est ajustée dans et/ou en travers de ou parallèlement sur le côté à la direction du champ magnétique principal (MH) de service du tomographe MR prévu, que les départs (27, 39) des deux fixations (24, 26, 22, 19, 23, 27, 37, 34, 31, 36, 38, 39) sont reliés directement ou indirectement, chacun à un ou en commun à une seule partie mobile du guidage droit ou de la liaison par ressort coulissant, et que les parties mobiles du guidage et de la liaison par ressort coulissant et la partie fixe du guidage à siège coulissant sont reliées en ayant une forme complémentaire.

11. Fixation de bobine réceptrice selon les revendications 1 à 10,
**caractérisée par le fait qu'**au moins une des fixations (24, 26, 22, 19, 23, 27, 37, 34, 31, 36, 38, 39) est fixée directement ou indirectement sur la pièce mobile (43) d'un palier (43, 46), que cette pièce mobile (43) du palier (43, 46) est disposée de façon à pouvoir effectuer une rotation autour d'une pièce porteuse (46) du palier (43, 46), que l'axe longitudinal de la pièce porteuse (46) est ajusté de façon forcée en direction de et dans la direction contraire de la direction du champ magnétique principal (MH) prévue ou en direction horizontale parallèlement à ce dernier, et que la pièce porteuse (46) s'appuie directement ou indirectement sur la plaque de base (1) et que sa distance verticale par rapport à celui-ci peut être réglée.

12. Fixation de bobine réceptrice selon les revendications 1 à 11,
**caractérisée par** la distance entre les boîtiers (18, 17) et leur array (de bobine) multiéléments (14, 16) l'un par rapport à l'autre, vue dans le sens transversal par rapport à la direction du champ magnétique principal (MH) de service peut être réglée.

13. Fixation de bobine réceptrice selon les revendications 1 à 12,
**caractérisée par le fait que** la position des boîtiers (18, 17) avec leur array (de bobine) multiéléments (14, 16) peut être réglée dans et inversement à la direction prévue vue du champ magnétique principal (MH).

14. Fixation de bobine réceptrice selon les revendications 1 à 13,
**caractérisée par le fait que** les boîtiers (18, 17) sont disposés de façon à pouvoir être pivotés et arrêtés au moyen d'une articulation (21, 32) ayant 2 ou 3 degrés de liberté dans la zone de l'extrémité (24, 37) de leurs fixations (24, 26, 22, 19, 23, 27, 37, 34, 31, 36, 38, 39).
